# EUROPEAN PATENT SPECIFICATION

(11) **EP 0 561 099 B1**
(45) Date of publication and mention of the grant of the patent: **06.09.1995**
(21) Application number: 92830140.7
(22) Date of filing: 20.03.1992
(51) Int. Cl.: H03H 11/04

(54) **Circuit device for suppressing the dependence from temperature and production process variables of the transconductance of a differential transconductor stage**
Schaltungsanordnung zur Abhängigkeitsunterdrückung vom Temperatur und von Herstellungsvariabelen der Steilheit einer differentiellen Transkonduktanzstufe
Circuit pour supprimer la dépendance de la température et des variables de production, de la transconductance d'un étage transconducteur différentiel

(43) Date of publication of application: 22.09.1993
(73) Proprietor: SGS-THOMSON MICROELECTRONICS s.r.l., 20041 Agrate Brianza (Milano) (IT)
(72) Inventor: Alini, Roberto, I-27049 Stradella (PV) (IT); Rezzi, Francesco, I-26039 Vascovato (CR) (IT); Vai, Gianfranco, I-27100 Pavia (IT); Gregori, Marco, I-20131 Milano (IT)
(74) Representative: Checcacci, Giorgio

(56) References cited:
- US-A- 4 723 108
- IEEE 1983 INTERN. SYMP. ON CIRCUITS AND SYSTEMS; 2-4 MAY 1983; G.M. GLASFORD: "CURRENT DEVELOPMENTS IN CMOS ...", pages 1282-1285
- 1990 IEEE INT. SYMP. ON CIRCUITS AND SYSTEMS; 1-3 MAY 1990; G.A. DE VEIRMAN et al.: "FULLY INTEGRATED 5 TO 15 MHZ PROGRAMMABLE BIPOLAR BESSEL LOWPASS FILTER", pages 1155-1158

## Description

This invention relates to a circuit device for suppressing the dependence from temperature and production process variables of the transconductance of a differential transconductor stage incorporating a polarization circuit.

A transconductor stage is a voltage controlled current amplifier stage. An ideal transconductor provides an output current which is equal to its input voltage current multiplied by a transconductance gₘ.

Transconductor are generally used in active filters, oscillators and circuit for impedance transformation. The invention is particularly, but not exclusively, concerned with continuous-time monolithic filters, and the description that follows will make reference to this field of application for convenience of illustration.

As is known, of the many techniques which have been proposed heretofore for making continuous-time monolithic filters, a technique which uses a transconductor differential stage as the base block for the filter is gaining increasing acceptance. Associated with the stage is, of course, an appropriate polarization circuit. Such a technique has proved specially effective in high-frequency applications. However, transconductor filters also have a drawback in that the transconductance value gm of the differential stage is tied to the operating temperature and the process of monolithic integration involved by the circuit fabrication.

In addition, the transconductance value is also dependent on a supply current Ib to the polarization circuit associated with the differential stage. The variability of the transconductance gₘ with the above parameters adversely affects the width of the filter pass band, restricting its performance esepecially at high frequencies.

A specific example of the literature on transconductor design is the following: "Fully integrated 5 to 15 MHz programmable bipolar bessel lowpass filter", 1990 IEEE International Symposium on circuits and systems, Vol. 2, which relates to a continuous-time filter based on a Gilbert multiplier cell whose transconductance common-mode output level is stabilized by a negative feedback loop. This negative loop compares the DC output voltages to a desired reference and controls bipolar current sources incorporated in the tranconductor stage. However, it doesn't modify the transconductance value gₘ.

Another prior art solution is disclosed in the US patent No. 4,723,108 which relates to a reference circuit for compensating the natural response of MOS circuits to changes in temperature and manufacturing variances. This reference circuit acts on the gate bias voltage of the MOS transistor to compensate for variations in temperature.

The underlying technical problem of this invention is to provide a circuit device which has such structural and operational features as to suppress the dependence on temperature, and on the integration process variables, of the transconductance of a transconductor stage, thereby overcoming the limitations with which prior devices have been beset.

Another object of the invention is to provide a circuit device which allows the user to control and set the value of said transconductance to suit the applicational requirements of the differential stage.

The solutive idea on which this invention stands is one of so adjusting the value of the supply current Ib to the polarization circuit associated with the differential stage as to accommodate any unbalance effects on the transconductance from temperature and process variables.

Starting from this solutive idea, the technical problem is solved by a circuit device as defined in the characterizing part of Claim 1.

The features and advantages of the device according to the invention will be apparent from the following detailed description of an embodiment thereof, given by way of example and not of limitation with reference to the accompanying drawings.

In the drawings:
Figure 1 is a diagram depicting the circuit device of this invention;
Figure 2 is a more detailed diagram of the device shown in Figure 1;
Figure 3 shows a modified embodiment of the device in Figure 1;
Figure 4 is a diagram illustrating an exemplary application of the inventive device; and
Figure 5 and 6 are respective diagrams showing details of the device in Figure 1.

With reference to the drawing figures, generally and schematically shown at 1 is a circuit device embodying this invention and effective to suppress the dependence on temperature and variables of the production process of the transconductance gm of a so-called transconductor stage 2. The device 1 is of the monolithic type.

Dependence on production process variables means here the effect on transconductance of the process steps whereby the transconductor circuit is made using conventional very large scale integration techniques.

The structure of stage 2 is known per se and from pertinent technical literature. This stage 3 is fabricated using a mixed technology, in that it includes both bipolar transistors and field-effect MOS transistors.

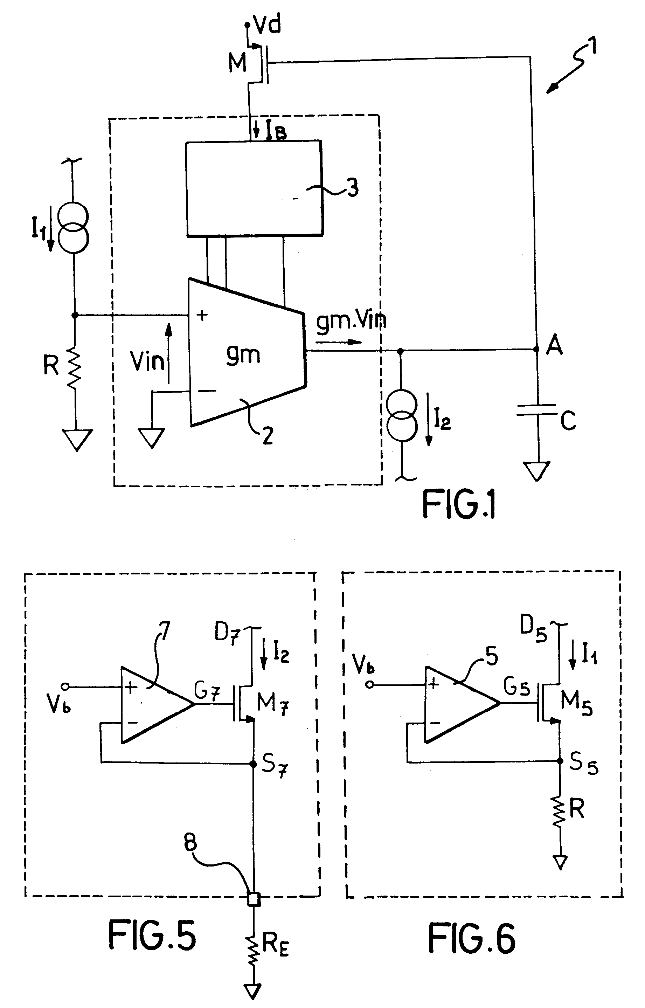

Associated with the stage 2 of figure 1 is a polarization circuit 3 connecting said stage to a positive voltage supply pole Vd. In addition, the inverting (-) input of stage 2 is connected directly to a reference potential, while the other, non-inverting (+) input is connected both to the pole Vd, via a current source I1, and to a reference potential via a resistor R.

Across said inputs, a voltage signal Vin is applied to produce, on an output U of stage 2, a current signal resulting from the product gm*Vin, where gm is the transconductance value of stage 2.

Advantageously, the device 1 of this invention comprises a negative feedback loop having a uniquely simple structure. This loop is closed across the output U of stage 2 and an input of the polarization circuit 3. Incorporated to the feedback loop are: a current generator I2, a capacitor C, and a transistor M of the MOS type.

Making reference to figure 1, it may be noted that the output U of the stage 2 is connected to the reference potential through the parallel connection between the generator I2 and the capacitor C. The connection point is indicated as node A and is connected also to the gate electrode G of the transistor M.

This transistor M is of the p-channel type, and has its source electrode S connected to the voltage pole Vd and its drain electrode D connected to the input end of the polarization circuit 4 to supply said circuit with a current Ib.

As previously mentioned, the transconductance gm is also dependent on the value of the supply current Ib to circuit 3. Assuming this dependence to be of a proportional nature, it is found that:$\text{gm = Kv*Ib}$
where Kv is a proportionality constant >0.

With the additional assumption that:$\text{I1 = Vb/R and I2 = Vb/Re}$
where Vb is a voltage derived from the supply voltage, e.g. $\text{Vb = Vd/2}$ , and Re is an external resistance to the integrated circuit whose value is accurately predetermined, the following relation can be obtained:$\text{(1) Vin = R*I1 = Vb}$

Illustrated in Figure 6 is an embodiment of the generator I1, incorporating an operational amplifier 5 which has a non-inverting (+) input supplied with the voltage Vb and the output connected to the gate electrode G5 of an n-channel MOS transistor M5. The inverting (-) input of amplifier 5 is instead connected to the source S5 of transistor M5, which is also connected to a reference potential through the resistor R.

Current I1 flows through transistor M5 from the drain D5 to the source S5.

The feedback loop of device 1 acts on the voltage appearing at node A to equalize the current output from stage 2 to current generator I2, and hence, such that:$\text{(2) gm*Vin = I2}$
but when the value of Vin from the previous relation (1) is substituted in this relation, then it is found that:$\text{(3) gm*Vb = I2 = Vb/Re}$
whence$\text{gm = 1/Re}$

Consequently, the feedback loop brings the circuit node A to such a voltage level as to bias to the active zone the transistor M, which will supply the current Ib directly into the polarization circuit 3 of stage 2. The latter is biased to the linear operation zone by effecting a linear voltage-to-current conversion and achieving a transconductance value gm = 1/Re.

The external resistance Re has a value which is defined by the user and is only required to be a temperature-wise stable kind because it is on it that the transconductance value gm obtained through the inventive device is dependent.

Shown in Figure 5 is an embodiment of the generator I2 which includes an operational amplifier 7 having its non-inverting (+) input supplied with a Vb voltage value and its output connected to the gate G7 of a MOS transistor M7. The source electrode S7 of this transistor is connected to the inverting (-) input of amplifier 7, and to a pin 8 of the integrated circuit incorporating the device of this invention.

Connected across said pin 8 and the reference potential is the external resistance Re.

In the embodiment described with reference to Figure 1, the dynamic resistance across the node A and the reference potential is theoretically an infinite value. However, to ensure stability of feedback loop, the provision of capacitor C is required to introduce in the frequency response a dominant pole useful to make sufficiently low the unitary gain frequency of the feedback loop, if compared to those of the other secondary poles in the feedback loop.

The capacitance of capacitor C is preferably lower than 30 pF, that is, enough to allow integration thereof.

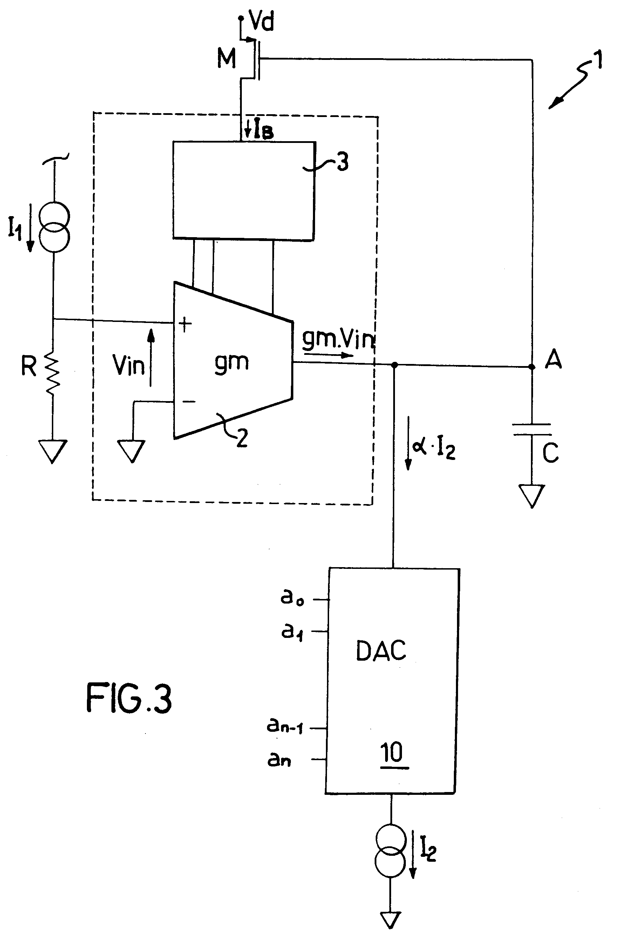

In a preferred embodiment shown in Figure 3, the current source or generator I2 is associated with a DAC (Digital to Analog Converter) converter 10 having a plurality n of digital selection inputs a0, a1,...,an. Each of these inputs represents one bit of an n-bit digital word selected by the user, which word allows the value of a multiplier parameter α to be defined which turns the current generator I2 into a variable current generator having a value of α*I2.

The value of α is proportional to the input values in accordance with the following expression:${\text{α ≅ a₀*2⁰ + a₁*2¹ + ...+ a}}_{\text{n}} {\text{*2}}^{\text{n}}$

Revising relations (1) and (2) in the light of the variable current generator α*I2, it is found that:$\text{(4) gm*Vin = gm*Vb = α*I2 = α*Vb/Re}$
whence:$\text{(5) gm = α/Re}$
The transconductance value gm, which is made independent of temperature and process variables by means of the circuit loop according to the invention, can be controlled and set by the user defining the parameter α.

The device of this invention has proved effective even where plural transconductor stages were to be operated.

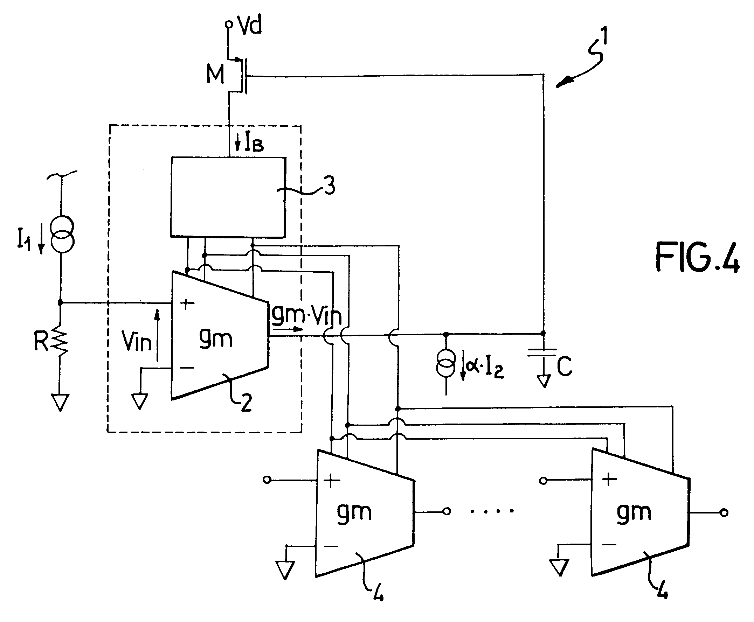

Figure 4 shows an embodiment of a circuit structure wherein plural stages 4, each having a transconductance value which is nominally the same as that of stage 2, are arranged in parallel and supplied through the same polarization circuit 3.

Here again, the feedback loop 1 associated with stage 2 and circuit 3 can accommodate the effects on transconductance of all stages 2 and 4, as due on temperature and process variables.

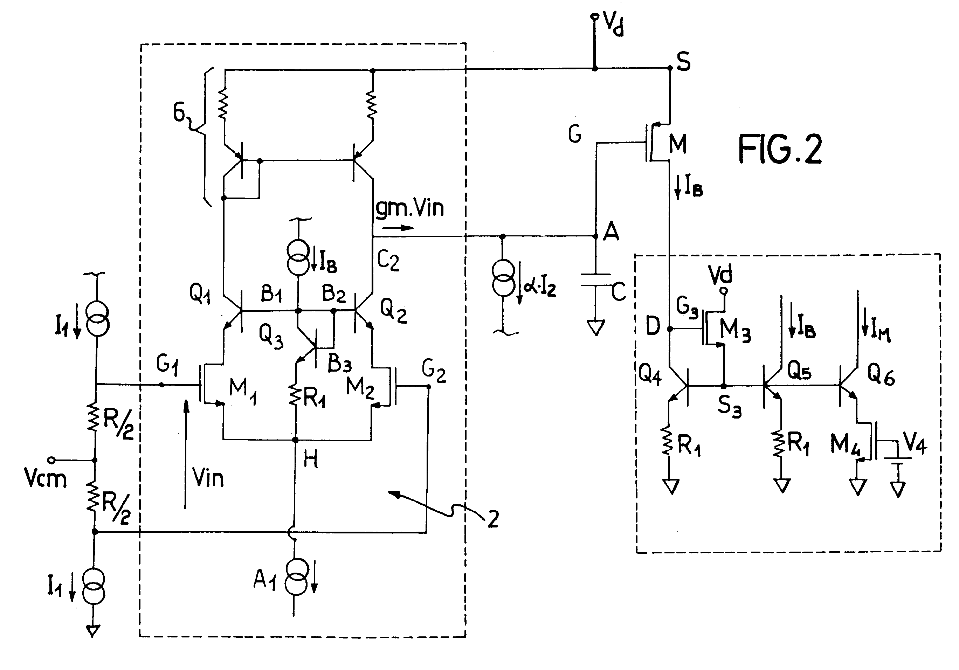

For completeness of discussion, a detailed example of the best mode currently contemplated of implementing the inventive device shown in Figure 2 will be given herein below.

The transconductor stage 2 is a differential type comprising an input portion formed of a pair of n-channel MOS transistors M1, M2 which have their source terminals in common and define a circuit node H. Connected between said node and a reference potential is a current source A1.

The gate terminal G1 of the first-named transistor, M1, constitutes a non-inverting (+) input for the differential stage. The gate G2 of the second-named transistor, M2, constitutes the inverting (-) input, and the voltage Vin is applied across said inputs.

To avoid distortion phenomena in the output current, the input voltage Vin is applied within the transconductor linear field through a resistive divider connected across said inputs of stage 2 and composed of a pair of resistors having a value of R/2.

To the junction point of the resistors, a so-called common mode voltage Vcm is applied, with the current sources I1 connecting, on the one side, the non-inverting (+) input to the supply pole Vd, and on the other side, the inverting (-) input to a reference potential.

In this way, the input voltage Vin is made to coincide with the previously discussed value Vb, but disposed in an exactly differential manner relatively to the common mode voltage Vcm.

Stage 2 also includes an output portion comprising a pair of npn bipolar transistors Q1 and Q2 which have their bases connected to each other. These transistors are connected in the stage 2 in a cascode configuration, and the collector C2 of one Q2 of them constitutes the output terminal for the differential stage 2.

A third transistor, Q3, of the bipolar type has its base B3 connected to the bases B1, B2, and its emitter connected to the node H via a resistor R1.

A current mirror circuit 6 is adapted to supply to the output A the current value gm*Vin produced by the MOS transistors M1 and M2.

The gate G of the transistor M is connected to collector C2, which is also connected to the reference potential by the parallel of the variable generator α*I2 and capacitor C. The sourse S of the same transistor M is connected to the Vd pole.

Finally, the polarization circuit 3 comprises a group of three bipolar transistors Q4, Q5, Q6 having respective bases in common. The two first-named transistors Q4, Q5 in this group have emitters taken to a reference potential, each through a resistor R1, and the third-named transistor Q6 has its emitter connected to the drain of a MOS transistor M4 which has its source grounded and gate connected to a costant voltage generator V4.

A further MOS transistor M3 has its gate and source respectively connected to the collector and the base of the first-named bipolar transistor Q4. The gate G3 of this MOS transistor M3 is connected, moreover, to the drain D of transistor M and constitutes an input for the polarization circuit 3.

## Claims

1. A circuit device (1) for suppressing the dependence on temperature and production process variables of the transconductance (gₘ) of a differential transconductor stage (2) having voltage inputs and a current output (U), said transconductor stage further incorporating a polarization circuit (3) receiving a first bias current (Ib) to provide at least a second bias current to the transconductor stage (2), characterized in that it comprises a negative feedback loop (1) closed across the output (U) of the transconductor stage (2) and an input of the polarization circuit (3), said negative feedback loop including a current generator (I2) connected to said output (U), a capacitor (C) connected between said output (U) and a reference potential, and at least a feedback transistor (M) controlled by the voltage on said current output (U) and connected to source current (Ib) to said polarization circuit (3).

2. A device according to Claim 1, characterized in that said output (U) is connected to the reference potential through the parallel of said current generator (I2) and said capacitor (C), and to a gate electrode (G) of said transistor (M).

3. A device according to Claim 1, characterized in that said transistor (M) is a P-Channel field effect transistor connected in the feedback loop (1) with respective drain (D) and source (S) electrodes interconnecting the polarization circuit (3) and a supply voltage (Vd) pole, and with the gate electrode (G) connected to said output (U).

4. A device according to Claim 1, characterized in that said current generator (I2) comprises a substantially temperature-independent external resistor.

5. A device according to Claim 1, characterized in that said current generator (I2) has a varying value.

6. A device according to Claim 1, characterized in that said current generator (I2) is connected to a digital-to-analog converter (10) having n digital selection inputs (a0,...,an) wherethrough the user is enabled to define a multiplier parameter α whose value modulates that of the current generator (I2).

7. A device according to Claim 1, characterized in that said current generator (I2) includes an operational amplifier (7) having a non-inverting (+) input supplied with a predetermined voltage value (Vb) and an output connected to the gate (G7) of a MOS transistor (M7), with said transistor (M7) having a source (S7) connected to the inverting (-) input of the amplifier (7).

8. A device according to Claim 7, characterized in that said source (S7) is connected to a reference potential through a resistance (Re) having a stable value with temperature.

9. An integrated circuit comprising: a plurality of differential transconductor stages (4), each having respective voltage inputs and at least a current output (U), at least a polarization circuit (3) to supply in parallel a bias current to all the transconductor stages (4), characterized in that it comprises a circuit device (1) for suppressing the dependence on temperature and production process variable of the transconductance (gₘ) of the transconductor stages (4), said circuit device (1) comprising a negative feedback loop closed across the output (U) of a first (2) of said stages (4) and an input of the polarization circuit (3) and including a current generator (I2) connected to said output (U), a capacitor (C) connected between said output (U) and a reference potential, and at least a feedback transistor (M) controlled by the voltage on said current output (U) and connected to source current (Ib) to said polarization circuit (3).

10. An integrated circuit according to Claim 9, characterized in that said output (U) is connected to a reference potential through a parallel of said current generator (I2) and said capacitor (C), and to the gate electrode (G) of said transistor (M).

11. An integrated circuit according to claim 9, characterized in that said feedback transistor (M) is a P-Channel MOS transistor having connected in the feedback loop (1) with respective drain (D) and source (S) electrodes interconnecting the polarization circuit (3) and a supply voltage (Vd) pole, and with the gate electrode (G) connected to said output (U).

## Patentansprüche

1. Schaltungsvorrichtung (1) zum Unterdrücken der Abhängigkeit der Steilheit (gₘ) einer Differenz-Transkonduktanzstufe (2) mit Spannungseingängen und einem Stromausgang (U) von der Temperatur und Fertigungsprozeßvariablen , wobei die Transkonduktanzstufe außerdem eine Polarisierungsschaltung (3) beinhaltet, die einen ersten Vorstrom (Ib) aufnimmt, um mindestens einen zweiten Vorstrom an die Transkonduktanzstufe (2) zu geben, dadurch gekennzeichnet, daß sie eine Gegenkopplungsschleife (1) aufweist, die parallel zum Ausgang (U) der Transkonduktanzstufe (2) und zu einem Eingang der Polarisierschaltung (3) geschlossen ist, die Gegenkopplungsschleife eine Stromquelle (I2), die an den Ausgang (U) angeschlossen ist, einen zwischen den Ausgang (U) und einem Bezugspotential liegenden Kondensator (C) und mindestens einen Rückkopplungstransistor (M) enthält, welcher durch die Spannung an dem Stromausgang (U) gesteuert wird und an eine Stromquelle (Ib) für die Polarisierschaltung (3) angeschlossen ist.

2. Vorrichtung nach Anspruch 1, dadurch gekennzeichnet, daß der Ausgang (U) an das Bezugspotential über den Parallelkreis aus der Stromquelle (I2) und dem Kondensator (C), und an eine Gate-Elektrode (G) des Transistors (M) angeschlossen ist.

3. Vorrichtung nach Anspruch 1, dadurch gekennzeichnet, daß der Transistor (M) ein P-Kanal-Feldeffekttransistor ist, der so in die Rückkopplungsschleife (1) verschaltet ist, daß seine Drain-Elektrode (D) und seine Source-Elektrode (S) mit der Polarisierschaltung (3) bzw. einem Versorgungsspannungsknoten (Vd) verbunden sind, während die Gate-Elektrode (G) mit dem Ausgang (U) verbunden ist.

4. Vorrichtung nach Anspruch 1, dadurch gekennzeichnet, daß die Stromquelle (I2) einen praktisch temperaturunabhängigen externen Widerstand aufweist.

5. Vorrichtung nach Anspruch 1, dadurch gekennzeichnet, daß die Stromquelle (I2) einen sich ändernden Wert aufweist.

6. Vorrichtung nach Anspruch 1, dadurch gekennzeichnet, daß die Stromquelle (I2) an einen Digital-Analog-Wandler (10) mit n digitalen Auswahleingängen (a0, ....., an) angeschlossen ist, wodurch der Anwender imstande ist, einen multiplikativen Parameter α zu definieren, dessen Wert denjenigen der Stromquelle (I2) moduliert.

7. Vorrichtung nach Anspruch 1, dadurch gekennzeichnet, daß die Stromquelle (I2) einen Operationsverstärker (7) enthält, dessen nicht-invertierender Eingang (+) eine vorbestimmte Spannung (Vb) empfängt, und dessen Ausgang an das Gate (G7) eines MOS-Transistors (M7) angeschlossen ist, wobei der Transistor (M7) mit einer Source (S7) an den invertierenden Eingang (-) des Verstärkers (7) angeschlossen ist.

8. Vorrichtung nach Anspruch 7, dadurch gekennzeichnet, daß die Source (S7) über einen Widerstand (Re) mit einem temperaturstabilen Wert an ein Bezugpotential angeschlossen ist.

9. Integrierte Schaltung, umfassend: Mehrere Differenz-Transkonduktanzstufen (4), die jeweils Spannungseingänge und mindestens einen Stromausgang (U) aufweisen, ferner mindestens eine Polarisierschaltung (3) zum parallelen Einspeisen eines Vorstroms in sämtliche Transkonduktanzstufen (4), dadurch gekennzeichnet, daß sie aufweist: eine Schaltungsvorrichtung (1) zum Unterdrücken der Temperaturabhängigkeit der Steilheit (gₘ) der Transkonduktanzstufe (4) von der Temperatur und von Fertigungsprozeßvariablen , wobei die Schaltungsvorrichtung (1) eine Gegenkopplungsschleife aufweist, die parallel zum Ausgang (U) einer ersten (2) der Stufen (4) und einem Eingang der Polarisierschaltung (3) geschlossen ist und eine Stromquelle (I2) enthält, die an den Ausgang (U) angeschlossen ist, wobei ein Kondensator (C) zwischen den Ausgang (U) und ein Bezugspotential gelegt ist, und mindestens einen Rückkopplungstransistor (M), der von der Spannung an dem Stromausgang (U) gesteuert wird und an eine Stromquelle (Ib) für die Polarisierschaltung (3) angeschlossen ist.

10. Integrierte Schaltung nach Anspruch 9, dadurch gekennzeichnet, daß der Ausgang (U) an ein Bezugspotential über einen Parallelkreis aus der Stromquelle (I2) und dem Kondensator (C), und an die Gate-Elektrode (G) des Transistors (M) angeschlossen ist.

11. Integrierte Schaltung nach Anspruch 9, dadurch gekennzeichnet, daß der Rückkopplungstransistor (M) ein P-Kanal-MOS-Transistor ist, der in der Rückkopplungsschleife (1) angeordnet ist, in dem seine Drain-Elektrode (D) und seine Source-Elektrode (S) mit der Polarisierschaltung (3) bzw. einem Versorgungsspannungsknoten (Vd) verbunden sind, während seine Gate-Elektrode (G) mit dem Ausgang (U) verbunden ist.

## Revendications

1. Dispositif formant circuit (1) pour supprimer la dépendance à la température et aux variables de production de la transconductance (gₘ) d'un étage transconducteur différentiel (2) ayant des entrées de tension et une sortie de courant (U), ledit étage transconducteur incorporant, en outre, un circuit de polarisation (3) recevant un premier courant de polarisation (Ib) pour fournir au moins un deuxième courant de polarisation à l'étage transconducteur (2), caractérisé en ce qu'il comprend une boucle de contre-réaction (1) entre la sortie (U) de l'étage transconducteur (2) et une entrée du circuit de polarisation (3), ladite boucle de contre-réaction comprenant un générateur de courant (I2) relié à ladite sortie (U), un condensateur (C) relié entre ladite sortie (U) et un potentiel de référence, et au moins un transistor de réaction (M) contrôlé par la tension sur ladite sortie de courant (U) et relié au courant source (Ib) dudit circuit de polarisation (3).

2. Dispositif selon la revendication 1, caractérisé en ce que ladite sortie (U) est reliée au potentiel de reférence par la parallèle dudit générateur de courant (I2) et dudit condensateur (C), et à une électrode de grille (G) dudit transistor (M).

3. Dispositif selon la revendication 1, caractérisé en ce que ledit transistor (M) est un transistor à effet de champ à canal P relié dans la boucle de réaction (1), les électrodes de drain (D) et de source (S) respectives faisant interconnexion entre le circuit de polarisation (3) et un pôle de tension d'alimentation (Vd), et l'électrode de grille (G) étant reliée à ladite sortie (U).

4. Dispositif selon la revendication 1, caractérisé en ce que ledit générateur de courant (I2) comprend une résistance externe sensiblement indépendante de la température.

5. Dispositif selon la revendication 1, caractérisé en ce que ledit générateur de courant (I2) a une valeur variable.

6. Dispositif selon la revendication 1, caractérisé en ce que ledit générateur de courant (I2) est relié à un convertisseur analogique-numérique (10) ayant n entrées de sélection numérique (a0,...,an), par lesquelles l'utilisateur peut définir un paramètre multiplicateur α dont la valeur module celle du générateur de courant (I2).

7. Dispositif selon la revendication 1, caractérisé en ce que ledit générateur de courant (I2) comprend un amplificateur opérationnel (7) ayant une entrée non inverseuse (+) alimentée par une valeur de tension prédéterminée (Vb) et une sortie reliée à la grille (G7) d'un transistor MOS (M7), ledit transistor (M7) ayant une source (S7) reliée à l'entrée inverseuse (-) de l'amplificateur (7).

8. Dispositif selon la revendication 7, caractérisé en ce que ladite source (S7) est reliée à un potentiel de référence par une résistance (Re) ayant une valeur stable avec la température.

9. Circuit intégré comprenant: une pluralité d'étages transconducteurs différentiels (4), chacun ayant des entrées de tension respectives et au moins une sortie de courant (U), au moins un circuit de polarisation (3) pour alimenter en parallèle tous les étages transconducteurs (4) en courant de polarisation, caractérisé en ce qu'il comprend un dispositif formant circuit (1) pour supprimer la dépendance de la transductance (gm) des étages transconducteurs (4) à la température et au procédé de production, ledit dispositif formant circuit (1) comprenant une boucle de contre-réaction entre la sortie (U) d'un premier (2) desdits étages (4) et une entrée du circuit de polarisation (3), et comprenant un générateur de courant (I2) relié a ladite sortie (U), un condensateur (C) relié entre ladite sortie (U) et un potentiel de référence, et au moins un transistor de réaction (M) contrôlé par la tension sur ladite sortie de courant (U) et relié au courant source (Ib) dudit circuit de polarisation (3).

10. Circuit intégré selon la revendication 9, caractérisé en ce que ladite sortie (U) est reliée à un potentiel de référence par une parallèle dudit générateur de courant (I2) et dudit condensateur (C), et à l'électrode de grille (G) dudit transistor (M).

11. Circuit intégré selon la revendication 9, caractérisé en ce que ledit transistor de réaction (M) est un transistor MOS à canal P relié dans la boucle de réaction (1), les électrodes de drain (D) et de source (S) respectives faisant interconnexion entre le circuit de polarisation (3) et un pôle de tension d'alimentation (Vd), et l'électrode de grille (G) étant reliée à ladite sortie (U).
